# EUROPÄISCHE PATENTSCHRIFT

(11) **EP 1 525 662 B1**
(45) Veröffentlichungstag und Bekanntmachung des Hinweises auf die Patenterteilung: **18.05.2011**
(21) Anmeldenummer: 03729767.8
(22) Anmeldetag: 23.06.2003
(51) Int. Cl.: H03L 7/099

(54) **DIGITAL GESTEUERTER OSZILLATOR**
DIGITALLY-CONTROLLED OSCILLATOR
OSCILLATEUR A COMMANDE NUMERIQUE

(30) Priorität: 27.06.2002 CH 111102
(43) Veröffentlichungstag der Anmeldung: 27.04.2005
(73) Patentinhaber: BridgeCo, Inc., El Segundo CA 90245 (US)
(72) Erfinder: ROTH, Eric, CH-8645 Jona (CH)
(74) Vertreter: Hackett, Sean James
(86) Internationale Anmeldenummer: PCT/CH2003/000405
(87) Internationale Veröffentlichungsnummer: WO 2004/004125

(56) Entgegenhaltungen:
- US-A- 6 114 915
- US-A1- 2002 008 557
- US-B1- 6 222 407
- US-B1- 6 259 330

## Beschreibung

Die Erfindung betrifft einen digital gesteuerten Oszillator gemäss dem Oberbegriff des unabhängigen Patenanspruchs.

Die Übermittlung von Audio- und Videodaten in Echtzeit erfordert eine Übereinstimmung der Datenrate am Sender und Empfänger, um die Beeinträchtigung der Wiedergabequalität durch Unter- oder Überläufe von Zwischenspeichern für Daten (Buffer) zu vermeiden. Der Empfänger muss demnach auch Taktinformation erhalten, welche die exakte Datenrate zu allen Zeitpunkten definiert. Diese Taktinformation kann vom Sender selbst oder aber von einer externen Taktreferenz stammen, wobei im letztgenannten Fall auch der Sender auf diese externe Taktreferenz synchronisiert werden muss.

In beiden Fällen muss jedoch Taktinformation verteilt werden. Dabei ist häufig die Übertragung nicht ideal, d.h. der Takt wird bei der Verteilung mit Jitter überlagert. Deshalb kommt häufig eine Taktrückgewinnung zum Einsatz, deren Aufgabe es ist, diesen Jitter mittels Filterung zu unterdrücken bzw. zu reduzieren (und gegebenenfalls auch die Taktfrequenz zu vervielfachen).

Eine Taktrückgewinnung mit Jitterunterdrückung wird in der Regel durch eine Phasenabgleichsschaltung PLL (Phase-locked loop) implementiert. Als Taktgenerator für die PLL werden häufig spannungsgesteuerte Oszillatoren VCO (Voltage controlled oscillator) eingesetzt. Solche VCOs haben als analoge Schaltungen jedoch den Nachteil, dass sie nur umständlich auf einem anwendungsspezifischen integrierten Schaltkreis ASIC (application specific integrated circuit) integriert werden können.

Digital gesteuerte Oszillatoren DCO (Digital controlled oscillator) sind einem analogen VCO nicht nur bezüglich Integrierbarkeit in einem ASIC, sondern auch hinsichtlich ihres Leistungs- und Flächenbedarfs deutlich überlegen. Die meisten DCOs basieren auf einer DLL (Delay-locked loop) oder einem Ringoszillator. Ringoszillatoren können zwar zur Jitterunterdrückung (Jitterfilterung) verwendet werden, die niedrige Frequenzauflösung und die hohe Anfälligkeit auf Eigenjitter beschränken jedoch den Anwendungsbereich von Ringoszillatoren. Herkömmliche DLL-basierte Implementationen von DCOs können zwar die Frequenz des Eingangssignals vervielfachen, bieten aber keine Jitterfilterung an, da es sich nicht um eine echte Frequenzsynthese handelt.

Eine PLL mit einer DLL-basierten Lösung für einen DCO ist bereits in der US-A-2002/0008557 beschrieben. Der DCO wird von einem stabilen Oszillator getaktet. Ferner umfasst der DCO einen Addierer, der eine gewünschte Ausgangsfrequenz generiert. Ein Eingangswort wird wiederholt zu einem Startwert des Addierers hinzu addiert, sodass der Addierer periodisch volläuft bzw. überläuft. Ist der Addierer vollgelaufen oder übergelaufen, so wird bei der nächsten ansteigenden Flanke des Eingangstakts (Takt vom stabilen Oszillator) eine ansteigenden Flanke des Ausgangssignals generiert. Falls bei der Generierung der ansteigenden Flanke des Ausgangssignals am Addierer ein sogenannter "Restterm" vorhanden ist (wenn also das zum Zählerstand der Addierers hinzu addierte Eingangswort grösser war als die noch vorhandene Kapazität des Addierers), so wird dieser Restterm (das ist derjenige Teil des Eingangsworts, der die Kapazität des Addierers überschreitet) in ein Register eingeschrieben und repräsentiert den zeitlichen Fehler des Ausgangssignals. Der Restterm wird dazu genutzt, eine mehrstufige Verzögerungsschaltung (Grobverzögerung, Feinverzögerung) anzusteuern. Die Verzögerungsschaltung weist mehrere Verzögerungsstufen (Grobverzögerungsstufe, Feinverzögerungsstufe) auf, wobei jede Verzögerungsstufe mit einzelnen diskreten Abgriffen hinter jedem Verzögerungselement versehen sind. Der Restterm steuert dabei, welcher der Abgriffe der Verzögerungsstufe jeweils abgegriffen wird, damit das Ausgangssignal (das ja einen zeitlichen Fehler aufweist, der durch den Restterm repräsentiert wird) so verzögert werden kann, dass der zeitliche Fehler des Ausgangssignals kompensiert wird und das entsprechend verzögerte Ausgangssignal dann wieder phasenrichtig ist.

Um den jeweils geeigneten Abgriff auszuwählen, beinhaltet die Verzögerungsstufe einen Multiplexer (Wähler), dessen Eingänge mit den einzelnen Abgriffen nach den jeweiligen Verzögerungselementen verbunden sind (und zwar jeweils ein Eingang des Multiplexers mit einem Abgriff hinter einem Verzögerungselement), sodass durch den Restterm der Multiplexer so angesteuert werden kann, dass der entsprechende Abgriff, bei dem das Ausgangssignal so verzögert ist, dass der zeitliche Fehler kompensiert ist.

Dies erfolgt derart, dass in einer Grobverzögerungsstufe aufgrund der darin enthaltenen Grobverzögerungselemente das Ausgangssignal zunächst grob verzögert wird. In der Grobverzögerungsstufe wird das Ausgangssignal so nahe wie möglich an die zur Kompensation des zeitlichen Fehlers erforderliche Verzögerung heran verzögert, wie dies aufgrund der Verzögerung der einzelnen Grobverzögerungselemente möglich ist (bestenfalls genau bis zur erforderlichen Verzögerung; ist dies aufgrund der Verzögerung der einzelnen Grobverzögerungselemente nicht genau möglich, dann bis zu derjenigen Grobverzögerung, die gerade noch unterhalb der zur Kompensation erforderlichen Verzögerung liegt). Sodann wird das von der Grobverzögerungsstufe verzögerte Signal in zumindest einer (oder auch in mehreren) Feinverzögerungsstufen weiter verzögert bis zum Erreichen der für die Kompensation des zeitlichen Fehlers erforderlichen Verzögerung (bzw. so nahe an diese heran, wie dies aufgrund der Verzögerung der einzelnen Feinverzögerungselemente eben möglich ist). Die Feinverzögerungsstufe ist so ausgebildet, dass beim Durchlaufen sämtlicher Feinverzögerungselemente (maximale Verzögerung der Feinverzögerungsstufe) eine Verzögerung auftritt, die genau einem Grobverzögerungselement entspricht.

Die Differenz zwischen der maximalen und der minimalen Verzögerung der gesamten Verzögerungsschaltung (Grobverzögerungsstufe und Feinverzögerungsstufen) beträgt genau eine Periode des Eingangstakts (Takt des stabilen Oszillators).

Wie bereits erwähnt, müssen die Eingänge des Multiplexers mit den vielen einzelnen Abgriffen einer solchen Verzögerungsstufe verbunden werden, was für die Implementation einer solchen Verzögerungsstufe in einer integrierten Schaltung (z.B. auf Silizium) erhebliche Schwierigkeiten bereitet, denn jeder Abgriff hinter einem Verzögerungselement muss mit einer gleich langen (oder besser gesagt: gleich kurzen) Verbindung mit dem Eingang des Multiplexers verbunden sein, damit es auf dem Weg von den Abgriffen hinter den einzelnen Verzögerungselementen zu den Eingängen des Multiplexers zu keinen relevanten Laufzeitunterschieden kommt (sonst wäre die Genauigkeit der Verzögerung zumindest erheblich beeinträchtigt, wenn nicht sogar die Funktionsfähigkeit ernsthaft in Frage stehen würde).

Bei der in der US-A-2002/0008557 beschriebenen Grobverzögerungsstufe sind dies alleine 64 Abgriffe, die mit den Eingängen des Multiplexers zu verbinden sind. Über die genutzten 64 Abgriffe hinaus beinhalten die einzelnen Verzögerungsstufen jedoch in der Regel noch eine deutlich grössere Anzahl von Verzögerungselementen, die jedoch nicht immer alle genutzt werden, aber deren Abgriffe dennoch mit den Eingängen des Multiplexers zu verbinden sind, weil man je nach Anwendung ja vorher nicht weiss, wie viele Verzögerungselemente bei einer bestimmten Anwendung tatsächlich benötigt werden. Somit werden unter Berücksichtigung der Vorgabe, dass keine relevanten Laufzeitunterschiede auftreten dürfen, wenn man die Laufzeit der Signale zwischen den jeweiligen Abgriffen und den zugehörigen Eingängen des Multiplexers betrachtet, die Schwierigkeiten bei der Implementation einer solchen Verzögerungsstufe in Silizium unmittelbar einsichtig.

Es ist daher eine Aufgabe der Erfindung, einen digital gesteuerten Oszillator der vorstehend genannten Art vorzuschlagen, bei welchem jedoch die Implementation der Verzögerungsschaltung in einer integrierten Schaltung (z.B. auf Silizium) erheblich erleichtert ist.

Diese Aufgabe wird durch den erfindungsgemässen digital gesteuerten Oszillator gelöst, wie er durch die Merkmale des unabhängigen Patentanspruchs 1 charakterisiert ist. Vorteilhafte Ausführungsbeispiele eines solchen digital gesteuerten Oszillators ergeben sich aus den Merkmalen der abhängigen Patentansprüche.

Insbesondere umfasst jedes Grobverzögerungselement und jedes Feinverzögerungselement einen eigenen ansteuerbaren Wähler. Dies hat den Vorteil, dass nicht eine grosse Vielzahl von auf einzelne Abgriffe verteilte Signale allesamt zu einem Wähler geführt werden müssen, der dann den jeweiligen - der erforderlichen Verzögerung entsprechenden - Abgriff auswählt. Dadurch wird eine einfachere Implementation in einer integrierten Schaltung möglich, weil eine Vielzahl von Abgriffen, nämlich hinter jedem einzelnen Verzögerungselement, nicht benötigt wird und auch nicht vorhanden ist.

Bei einem vorteilhaften Ausführungsbeispiel des erfindungsgemässen digital gesteuerten Oszillators umfasst das Grobverzögerungselement ein Verzögergungsglied und den Wähler, wobei ein Eingang des Wählers des jeweiligen Grobverzögerungselements mit dem Ausgang des Verzögerungsglieds des gleichen Grobverzögerungselements und ein weiterer Eingang des Wählers mit dem Ausgang des Wählers des unmittelbar nachgeschalteten Grobverzögerungselements verbunden ist. Das heisst, dass jeder Wähler im Prinzip nur zwei Signalzuführungen benötigt, nämlich das Ausgangssignal seines eigenen Verzögerungsglieds und das Ausgangssignal des Wählers des unmittelbar nachgeschalteten Verzögerungselements. Damit ist eine Implementation in Silizium auf besonders einfache Weise möglich, separate Abgriffe nach den einzelnen Verzögerungselementen existieren nicht und werden auch nicht benötigt.

Bei einem weiteren Ausführungsbeispiel des erfindungsgemässen digital gesteuerten Oszillators weist das Feinverzögerungselement einen gemeinsamen Eingang auf, sowie mindestens zwei mit dem gemeinsamen Eingang verbundene Treiber. Am Ausgang von einem der beiden Treiber (im Falle von genau zwei Treibern) ist eine kapazitive Last vorgesehen. Ein Eingang des Wählers ist mit dem Ausgang des Treibers ohne die kapazitive Last und ein weiterer Eingang des Wählers mit dem Ausgang des Treibers mit kapazitiver Last verbunden. Der Ausgang des Wählers des jeweiligen Feinverzögerungselements ist mit dem gemeinsamen Eingang des unmittelbar nachgeschalteten Feinverzögerungselements verbunden. Durch das Aufladen der kapazitiven Last wird bewirkt, dass das Signal erst zu einem späteren Zeitpunkt anliegt, weil zunächst die kapazitive Last geladen werden muss. Da sowohl das Ausgangssignal des Treibers ohne kapazitive Last als auch das Ausgangssignal des Treibers mit kapazitiver Last an den Eingängen des Wählers anliegt, kann durch den Wähler auf einfache Weise ausgewählt werden, ob die durch die kapazitive Last bewirkte Verzögerung bei dem jeweiligen Verzögerungselement aktiviert ist oder nicht. Vorteilhaft daran ist auch, dass nur mit Treibern der gleichen Art eine Feinverzögerung erreicht werden kann, die kleiner ist als die Feinverzögerung eines einzelnen Treibers, weil die Durchlaufzeiten des Signals durch die beiden Zweige sich um weniger unterscheiden als die Durchlaufzeit durch einen einzelnen Treiber.

Bei einem weiteren vorteilhaften Ausführungsbeispiel des erfindungsgemässen digital gesteuerten Oszillators umfasst das Feinverzögerungselement mehrere Treiber, deren Eingänge miteinander zu einem gemeinsamen Eingang und deren Ausgänge miteinander zu einem gemeinsamen Ausgang verbunden sind. Dabei ist der Wähler derart ausgebildet, dass die einzelnen Treiber aktivierbar oder deaktivierbar sind. Der gemeinsame Ausgang ist mit dem gemeinsamen Eingang des unmittelbar nachgeschalteten Feinverzögerungselements verbunden. Der Wähler ist hier so realisiert, dass die einzelne Treiber aktiviert ("enabling") werden können oder nicht. Die einzelnen Treiber weisen jeweils eine Eingangskapazität auf, und zwar unabhängig davon, ob der jeweilige Treiber aktiviert ist oder nicht. Je mehr Treiber in einem vorangehenden Feinverzögerungselement also aktiviert sind, desto weniger Zeit wird benötigt, bis die

Eingangskapazitäten des nachfolgenden Feinverzögerungselements aufgeladen sind, und desto schneller liegt dann das Ausgangssignal am gemeinsamen Ausgang an. Auf diese Weise lässt sich also sehr einfach die Verzögerungszeit der einzelnen Verzögerungselemente einstellen.

Ferner betrifft die Erfindung noch eine Digitale Phasenabgleichsschaltung, mit einem Eingangstaktsignal, einem Phasenkomparator, einem Filter und einem digital gesteuerten Oszillator, sowie mit einem Rückkopplungszweig, der ein von dem digital gesteuerten Oszillator erzeugtes Ausgangssignal zu dem Phasenkomparator zurückführt, gegebenenfalls unter Frequenzteilung. Der digital gesteuerte Oszillator ist dabei so ausgebildet wie vorstehend beschrieben.

Weitere vorteilhafte Ausgestaltungen des erfindungsgemässen digital gesteuerten Oszillators ergeben sich aus der nachfolgenden Beschreibung von Ausführungsbeispielen anhand der Zeichnung.

Es zeigen:
- Fig. 1: ein Blockschaltbild eines Ausführungsbeispiels einiger wesentlicher Elemente eines erfindungs- gemässen digital gesteuerten Oszillators (DCO),
- Fig. 2: eine Darstellung eines stabilen Eingangstakts des DCO und eines vom DCO erzeugten Ausgangstakts,
- Fig. 3: eine Periode des stabilen Eingangstakts mit einer möglichen Unterteilung dieser Periode in Zeitabschnitte, die den Verzögerungen der Grobverzögerungselemente und den Verzögerungen der Feinverzögerungselemente entsprechen,
- Fig. 4: ein Blockschaltbild zur Erläuterung des Kalibrier- vorgangs bei der Kalibrierung der Grobverzögerungs- stufe,
- Fig. 5: ein Blockschaltbild zur Erläuterung des Kalibrier- vorgangs bei der Kalibrierung der Feinverzögerungs- stufe,
- Fig. 6: ein Ausführungsbeispiel für eine Grobverzögerungs- stufe mit einzelnen Grobverzögerungselementen,
- Fig. 7: ein erstes Ausführungsbeispiel für eine Feinver- zögerungsstufe mit einzelnen Feinverzögerungs- elementen,
- Fig. 8: ein zweites Ausführungsbeispiel für eine Feinver- zögerungsstufe mit einzelnen Feinverzögerungs- elementen,
und
- Fig. 9: ein Blockschaltbild einer Phasenabgleichsschaltung (PLL) mit einem erfindungsgemässen DCO.

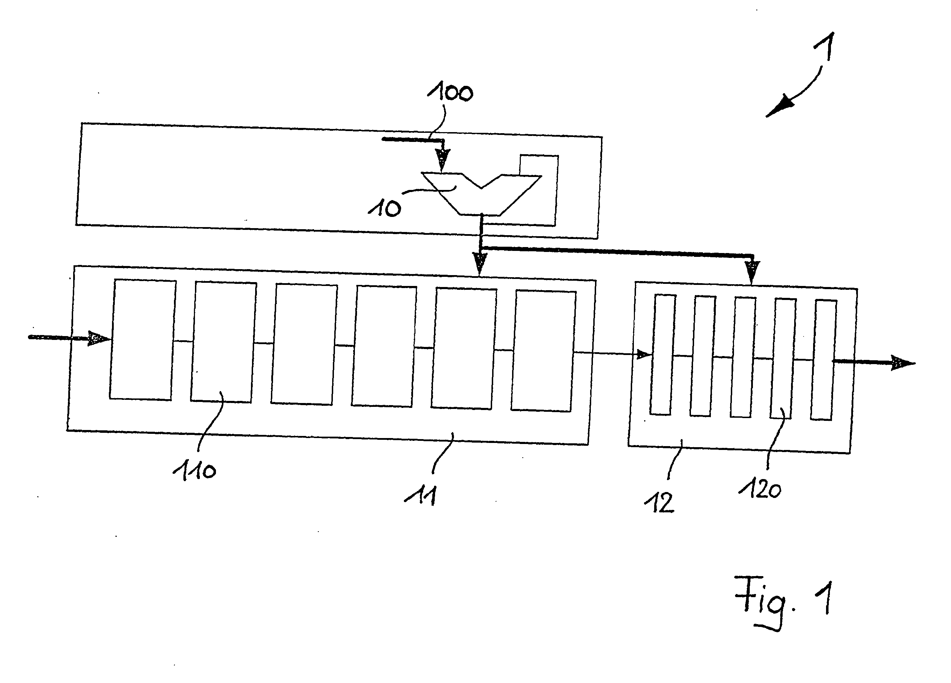

In dem Blockschaltbild in Fig. 1 erkennt man einige wesentliche Elemente eines Ausführungsbeispiels eines erfindungsgemässen digital gesteuerten Oszillators 1. Er umfasst einen Addierer 10 zum Aufsummieren von digitalen Eingangswörtern 100, welche dem Addierer 10 zugeführt werden. Diese digitalen Eingangswörter sind repräsentativ für die jeweils am Ausgang des digital gesteuerten Oszillators 1 erzeugte Frequenz. Die digitalen Eingangswörter 100 werden im Addierer 10 aufsummiert, der die Verzögerungsstufen, im hier gezeigten Ausführungsbeispiel eine Grobverzögerungsstufe 11 und eine Feinverzögerungsstufe 12, in noch näher zu erläuternder Weise ansteuert Die Grobverzögerungsstufe 11 umfasst mehrere Grobverzögerungselemente 110, die Feinverzögerungsstufe 12 umfasst mehrere Feinverzögerungselemente 120, wobei aus Gründen der besseren Übersichtlichkeit in Fig. 1 jeweils nur eine sehr begrenzte Anzahl von Grobverzögerungselementen 110 und Feinverzögerungselementen 120 dargestellt ist.

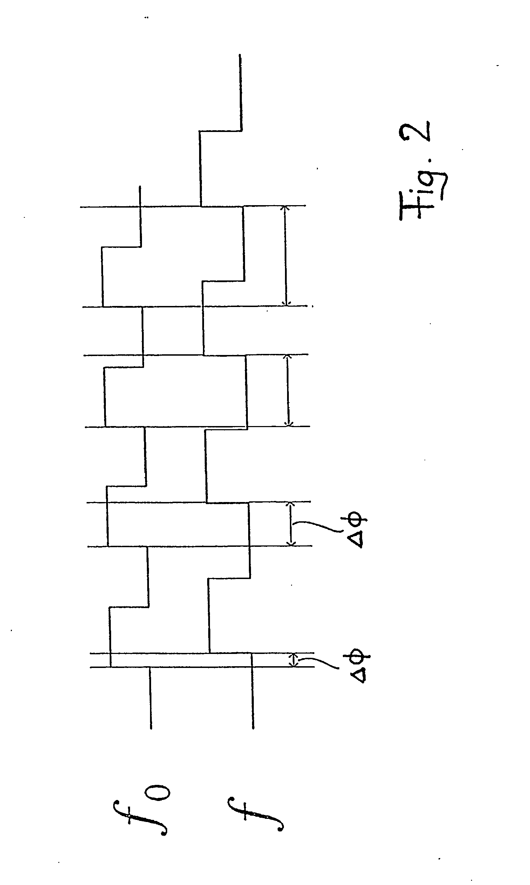

In Fig. 2 erkennt man den Eingangstakt eines stabilen lokalen Oszillators mit der konstanten Frequenz f₀, wobei der stabile lokale Oszillator in Fig. 1 nicht dargestellt ist, solche stabilen lokalen Oszillatoren (z.B. hochstabile Quartz-Oszillatoren) sind hinreichend bekannt. Die Ausgangsfrequenz f des von dem digital gesteuerten Oszillator erzeugten Ausgangstakts unterscheidet sich gegenüber der Frequenz f₀ des Eingangstakts, der von dem stabilen lokalen Oszillator erzeugt wird. Der digital gesteuerte Oszillator erzeugt hier also aufgrund der Eingangswörter eine Frequenz f, welche von der Frequenz f₀ des Eingangstakts verschieden ist.

Dies erkennt man in Fig. 2 auf einfache Weise daran, dass die Phasendifferenz ΔΦ zwischen der jeweiligen ansteigenden Flanke des Eingangstakts mit der Frequenz f₀ und der ansteigenden Flanke des Ausgangstakts mit der (hier ebenfalls konstanten) Frequenz f stets um einen konstanten Betrag zunimmt. Eine konstante Zunahme der Phasendifferenz ΔΦ bedeutet jedoch nichts anderes als einen konstanten Frequenzunterschied.

Im Prinzip geht es ja darum, mit Hilfe des digital gesteuerten Oszillators einen eventuell mit Jitter behafteten Takt durch einen jitterarmen Takt (gleicher Frequenz und Phase) zu ersetzen, der mit Hilfe des (jitterfreien) Eingangstakts des stabilen lokalen Oszillators (bzw. durch einen Takt mit einem Vielfachen oder einem Teil dieser Taktfrequenz) erzeugt wird, wobei auch die Verzögerungsstufen zum Einsatz kommen. Wie diese Nachbildung des Eingangstakts mit Hilfe eines (jitterfreien) Eingangstakts des stabilen lokalen Oszillators vom grundsätzlichen Prinzip her erfolgt, geht bereits aus der eingangs genannten US-A-2002/0008557 hervor.

Dazu muss allerdings bekannt sein, wie viele Grobverzögerungselemente 110 und wie viele Feinverzögerungselemente 120 erforderlich sind, und wie viele Feinverzögerungselemente 120 benötigt werden, um bei sämtlichen aktivierten Grobverzögerungselementen 110 die maximal zulässige Verzögerung (die Differenz zwischen maximaler und minimaler Verzögerung darf höchstens eine Periodendauer des stabilen Eingangstakts sein) zu bewirken.

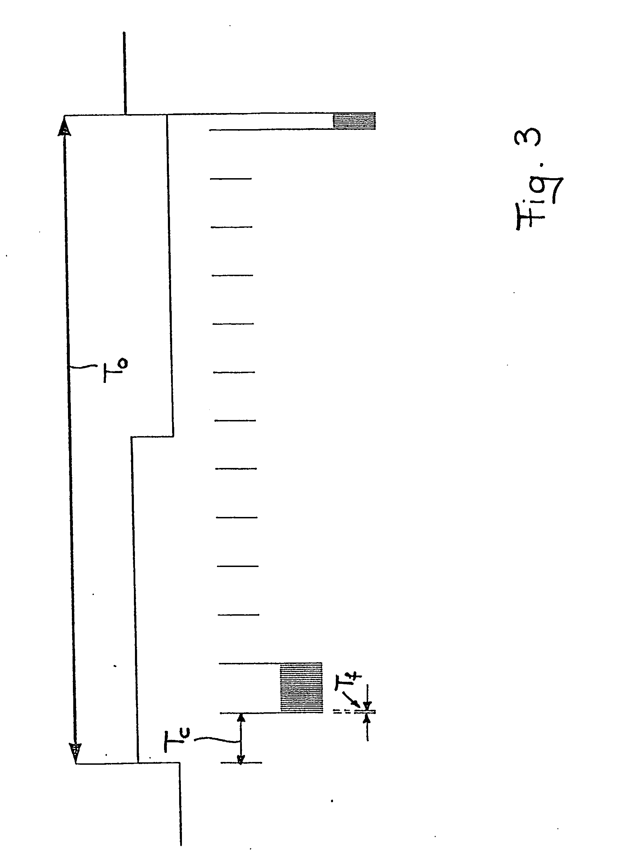

In Fig. 3 ist eine Periode des Eingangstakts mit der Frequenz f₀ und der entsprechenden Periodendauer T₀ (wobei gilt : T₀ = 1/f₀) dargestellt, mit einer möglichen Unterteilung der Periodendauer T₀ in Zeitabschnitte T_{c} bzw. T_{f}, die den Verzögerungen der Grobverzögerungselemente 110 (Fig. 1) und den Verzögerungen der Feinverzögerungselemente 120 (Fig.1) entsprechen.

Aus Fig. 3 lässt sich erkennen, dass die erforderliche Anzahl von Grobverzögerungselementen 110 so bestimmt wird, dass die Summe der Verzögerungen T_{c}, die von dieser Anzahl von Grobverzögerungselementen 110 bewirkt wird, gerade kleiner ist als eine Periodendauer T₀ des Eingangstakts. Die erforderliche Anzahl von Feinverzögerungselementen 120 wird hingegen so bestimmt, dass die Summe der Verzögerungen T_{f}, die von dieser Anzahl von Feinverzögerungselementen 120 bewirkt wird, gerade der Verzögerung T_{c} eines Grobverzögerungselements 110 entspricht. Ausserdem muss auch noch die erforderliche Anzahl von Feinverzögerungselementen 120 bestimmt werden, die erforderlich ist, um eine Gesamtverzögerung zu erreichen, die genau einer Periodendauer T₀ des Eingangstakts entspricht (bzw. gerade eben kleiner ist), also die Differenz zwischen der Periodendauer T₀ des Eingangstakts und der Verzögerung, die durch die zuvor bestimmte Anzahl von Grobverzögerungselementen bewirkt wird. Diese Differenz entspricht ebenfalls einer Anzahl von Feinverzögerungselementen, die jedoch kleiner ist als die insgesamt erforderliche Anzahl von Feinverzögerungselementen. Dennoch muss auch diese Anzahl von Feinverzögerungselementen bestimmt werden, da der Unterschied zwischen der maximalen und der minimalen Gesamtverzögerung, die durch beide Verzögerungsstufen zusammen bewirkt werden, kleiner sein muss als eine Periodendauer T₀ des Eingangstakts.

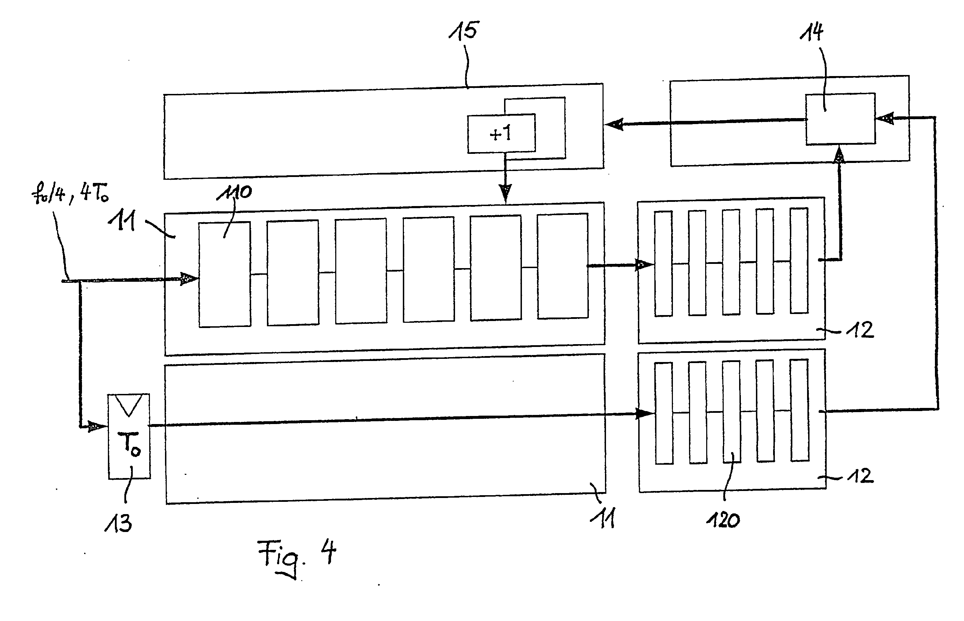

In Fig. 4 ist ein Blockschaltbild zu erkennen, wie der Kalibriervorgang bei der Kalibrierung der Grobverzögerungsstufe 11 erfolgt, also wie die Anzahl der Grobverzögerungselemente 110 bestimmt wird, die zusammen eine Grobverzögerung bewirken, die gerade noch unterhalb einer Periodendauer T₀ des Einganstakts vom stabilen lokalen Oszillator mit der Frequenz f₀ liegt. Zu diesem Zweck werden zwei Zweige mit einem stabilen Eingangstakt der Frequenz f₀/4 (Periodendauer 4T₀) als Signal beaufschlagt. Dieses Taktsignal mit der Frequenz f₀/4 kann beispielsweise durch sogenanntes "clock-gating" aus dem Taktsignal mit der Frequenz f₀ des stabilen lokalen Oszillators gewonnen werden (Frequenzteilung). Diese niedrigere Frequenz kann erforderlich werden, weil die "Offset-Verzögerungen" der Verzögerungsstufen 11,12 zu gross sein können, um das Taktsignal mit der Frequenz f₀ des stabilen lokalen Oszillators direkt verwenden zu können, was z.B. an der Wahl eines bestimmten Halbleiters für die integrierte Schaltung liegen kann. Bei der Wahl von sehr schnellen Halbleitern (oder einer niedrigeren Frequenz des stabilen lokalen Oszillators) kann auch die Frequenz f₀ des stabilen lokalen Oszillators direkt verwendet werden.

In dem ersten Zweig ist eine zu kalibrierende Grobverzögerungsstufe 11 enthalten, die eine Anzahl von Groberzögerungselementen 110 umfasst. An diese Grobverzögerungsstufe 11 schliesst sich eine Feinverzögerungsstufe 12 an, die im Leerlauf durchlaufen wird (kein Feinverzögerungselement aktiviert) und die im Grunde nur deshalb vom Signal durchlaufen wird, weil sie eine "Offset"-Verzögerung aufweisen kann, ohne dass auch nur ein einziges Feinverzögerungselement 120 aktiviert ist.

In dem zweiten Zweig durchläuft das Signal zunächst ein Verzögerungsglied 13, welches das Signal um genau die Dauer T₀ verzögert, das Signal im zweiten Zweig ist dann also gegenüber dem Signal im ersten Zweig um ein Viertelperiode verzögert. Sodann durchläuft das Signal eine Grobverzögerungsstufe 11, die im Leerlauf betrieben wird. Auch die daran anschliessende Feinverzögerungsstufe 12 im zweiten Zweig wird im Leerlauf betrieben (kein Feinverzögerungselement aktiviert).

Die Ausgangssignale der Feinverzögerungsstufen 12 in den beiden Zweigen wird nun einem Phasenkomparator 14 zugeführt, welcher die Phasen der beiden Signale miteinander vergleicht. Da das Signal, welches den zweiten Zweig durchlaufen hat, gegenüber dem Signal, welches den ersten Zweig durchlaufen hat, ohne Berücksichtigung der Grobverzögerungsstufe 11 im ersten Zweig um ein Viertel der Periodendauer (nämlich um T₀, man beachte: Periodendauer des Signals ist hier 4T₀) nacheilt, muss die Anzahl der Grobverzögerungselemente 110 in der zu kalibrierenden Grobverzögerungsstufe 11 im ersten Zweig nun so ermittelt werden, dass das Signal beim Durchlaufen der so ermittelten Anzahl von Grobverzögerungselementen 110 beinahe phasengleich mit dem Signal ist, welches den zweiten Zweig durchlaufen hat.

Dazu wird zunächst ein Grobverzögerungselement 110 im ersten Zweig aktiviert, und der Phasenkomparator 14 vergleicht jeweils die Phasen der Ausgangssignale der Feinverzögerungsstufen 12 in den beiden Zweigen. Entspricht die Phasendifferenz einer Verzögerung, die grösser ist als die Verzögerung durch ein Grobverzögerungselement 110, so wird durch eine Steuerung 15 ein weiteres Grobverzögerungselement 110 aktiviert. Anschliessend durchläuft wieder das Signal (stabiler Eingangstakt) die beiden Zweige und am Phasenkomparator 14 erfolgt ein erneuter Vergleich der Phasen. Dies wird so lange wiederholt, bis die Phasendifferenz am Phasenkomparator 14 gerade kleiner ist als sie einer Verzögerung durch ein Grobverzögerungselement 110 entspricht. Somit ist die erforderliche Anzahl von Grobverzögerungselementen 110 ermittelt.

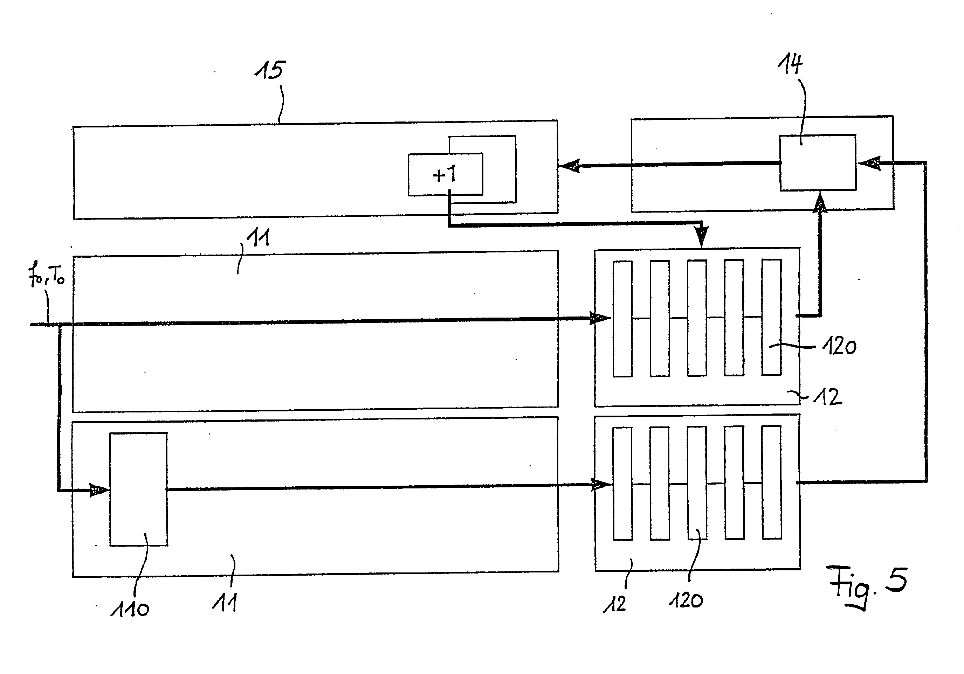

Wie die Kalibrierung der Feinverzögerungsstufe 12 erfolgt, kann man anhand von Fig. 5 erkennen. Es muss also die Anzahl von Feinverzögerungselementen 120 in einer Feinverzögerungsstufe 12 ermittelt werden, welche zusammen eine Verzögerung bewirken, die der Verzögerung eines einzigen Grobverzögerungselements 110 der Grobverzögerungsstufe 11 entspricht. Dazu werden zwei Zweige mit einem stabilen Eingangstakt, z.B. dem Takt vom stabilen lokalen Oszillator (Frequenz f₀, Periodendauer T₀) als Signal beaufschlagt.

Im zweiten Zweig durchläuft das Signal eine Grobverzögerungsstufe 11 mit einem einzigen aktivierten Verzögerungselement 110 und anschliessend eine im Leerlauf befindliche Feinverzögerungsstufe 12 (kein Feinverzögerungselement 120 aktiviert).

Im ersten Zweig durchläuft das Signal eine im Leerlauf befindliche Grobverzögerungsstufe 11 (kein Grobverzögerungselement 110 aktiviert) und anschliessend eine zu kalibrierende Feinverzögerungsstufe 12. Die Ausgangssignale der Feinverzögerungsstufen 12 in der beiden Zweige werden dem Phasenkomparator 14 zugeführt, welcher die Phasen der beiden Signale miteinander vergleicht.

Lässt man zunächst die durch die Feinverzögerungselemente 120 im ersten Zweig bewirkte Verzögerung ausser Acht, so ist das Ausgangssignal des zweiten Zweigs um die von dem einzigen aktivierten Grobverzögerungselement 110 bewirkte Grobverzögerung gegenüber dem Signal im ersten Zweig verzögert. Diese Verzögerung entspricht einer Phasendifferenz, die am Phasenkomparator 14 anliegt. Anschliessend durchläuft wieder das Signal (stabiler Eingangstakt) die beiden Zweige und am Phasenkomparator erfolgt ein erneuter Vergleich der Phasen. Dies wird so lange wiederholt, bis die Phasendifferenz am Phasenkomparator 14 gerade kleiner ist als sie einer Verzögerung durch ein Grobverzögerungselement 110 entspricht. Somit ist die erforderliche Anzahl von Grobverzögerungselementen 110 ermittelt.

Entspricht diese Phasendifferenz einer Verzögerung, die noch immer grösser ist als die Verzögerung eines Feinverzögerungselements 120, so wird durch die Steuerung 15 ein weiteres Feinverzögerungselement 120 in der Feinverzögerungsstufe 12 im ersten Zweig aktiviert. Anschliessend durchläuft wieder das Signal (stabiler Eingangstakt) die beiden Zweige und am Phasenkomparator erfolgt ein erneuter Vergleich der Phasen. Dies wird so lange wiederholt, bis die Phasendifferenz am Phasenkomparator 14 null ist (bzw. bis die Phasendifferenz einer Verzögerung entspricht, die kleiner ist als die Verzögerung eines Feinverzögerungselements 120). Die Anzahl der erforderlichen Feinverzögerungselemente 120, die einem Grobverzögerungselement 110 entsprechen, ist somit ermittelt.

Schliesslich muss noch ermittelt werden, wie viele Feinverzögerungselemente 120 zusätzlich zu der ermittelten Anzahl von Grobverzögerungselementen 110 erforderlich sind, um eine Verzögerung hervorzurufen, die genau der Periodendauer T₀ des Eingangstakts entspricht. Dies erfolgt prinzipiell auf die gleiche Art und Weise wie bei der Ermittlung der erforderlichen Anzahl von Grobverzögerungselementen 110 (also Frequenz f₀/4, Periodendauer 4T₀), wobei jedoch die Anzahl der Grobverzögerungselemente 110 vorgegeben ist (das ist nämlich diejenige Anzahl von Grobverzögerungselementen, die eine Verzögerung bewirken, die um weniger als die Verzögerung eines einzigen Grobverzögerungselements kleiner ist als die Periodendauer T₀ des Takts vom stabilen lokalen Oszillator). Es wird dann lediglich die Anzahl der Feinverzögerungselemente 120 bestimmt, die zusammen mit den Grobverzögerungselementen 110 eine Verzögerung bewirkt, die genau einer Periodendauer entspricht (bzw. eine Verzögerung bewirken, die um weniger als die Verzögerung eines einzigen Feinverzögerungselements kleiner ist als die Periodendauer des Eingangstakts).

Mit diesen drei Informationen (Anzahl der maximal erforderlichen Grobverzögerungselemente, Anzahl der maximal erforderlichen Feinverzögerungselemente, Anzahl der erforderlichen Feinverzögerungselemente zum Erreichen der maximalen Verzögerungsdauer) ist die Kalibrierung abgeschlossen.

Die jeweilige Gesamtverzögerung (Verzögerung der Grobverzögerungsstufe 11 und der Feinverzögerungsstufe 12) ist nun immer dem akkumulierten Zählerstand des Addierers 10 proportional. Wird ein Zählerstand erreicht, welcher der maximal möglichen Verzögerung entspricht, erfolgt ein sogenanntes "gating" (die nächste ansteigende Flanke des Eingangstakts wird ignoriert), der Zähler wird wieder zurückgesetzt, und der den maximalen Zählerstand überschreitende Teil des letzten Eingangsworts wird genutzt, um die Grobverzögerungsstufe 11 und die Feinverzögerungsstufe 12 anzusteuern. Anschliessend werden die digitalen Eingangswörter wieder so lange aufaddiert und der akkumulierte Zählerstand entspricht wieder der jeweiligen Gesamtverzögerung, bis der Zähler erneut überläuft, und so weiter.

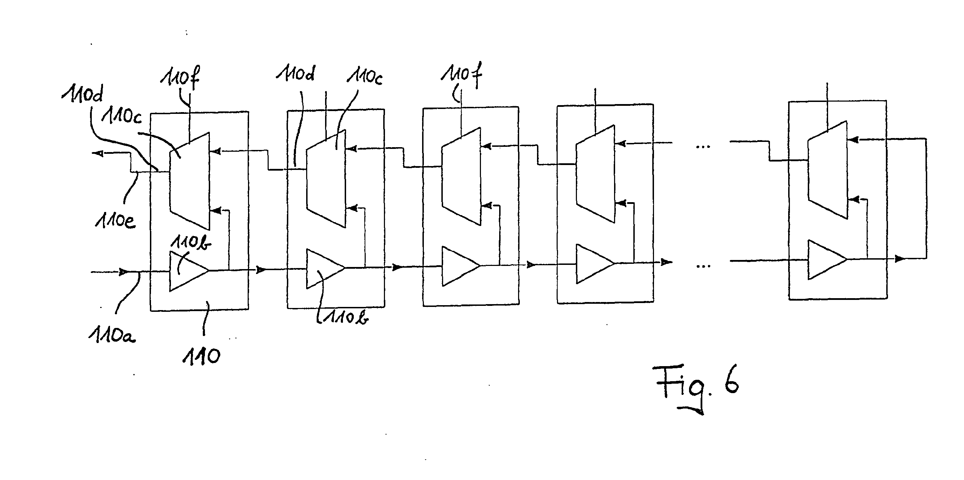

In Fig. 6 ist ein bevorzugtes Ausführungsbeispiel einer Grobverzögerungsstufe 11 mit einzelnen Grobverzögerungselementen 110 zu erkennen. Man erkennt, dass jedes Grobverzögerungselement 110 ein Verzögerungsglied 110b und einen Wähler 110c umfasst. Der Eingang des Wählers 110c des jeweiligen Grobverzögerungselements 110 ist mit dem Ausgang des gleichen Grobverzögerungselements 110 verbunden. Ein weiterer Eingang des Wählers 110c ist mit dem Ausgang des Wählers des unmittelbar nachgeschalteten Verzögerungselements 110 verbunden.

Betrachtet man beispielsweise das erste Verzögerungselement 110 (in Fig. 6 das ganz links angeordnete), so durchläuft das am Eingang 110a anliegende Signal zunächst das Verzögerungsglied 110b und liegt sodann bereits an einem Eingang des Wählers 110c des gleichen Verzögerungselements 110 an. Würde der Wähler 110c des ersten Verzögerungselements 110 so angesteuert, dass der Eingang des Wählers 110c, an welchem das von dem Verzögerungsglied 110b verzögerte Signal anliegt, auf den Ausgang 110d durchgeschaltet - der hier gleichzeitig dem Ausgang 110e der Grobverzögerungsstufe 11 entspricht, so würde das Ausgangssignal der Grobverzögerungsstufe 11 insgesamt lediglich um die durch das Verzögerungsglied 110a und den Wähler 110c bewirkte Verzögerung verzögert. Die nachgeschalteten Verzögerungselemente 110 wären entsprechend nicht aktiviert.

Die nachgeschalteten Verzögerungselemente 110 sind in gleicher Weise ausgebildet wie das erste Verzögerungselement 110, lediglich beim letzten Verzögerungselement 110 (das in Fig. 6 ganz rechts angeordnete) liegt an beiden Eingängen des Wählers 110c das gleiche Signal an, welches um eine der Anzahl der Verzögerungselemente 110 entsprechende Verzögerung an den Eingängen des Wählers 110c dieses letzten Verzögerungselements 110 anliegt.

Welches Signal jeweils auf den Ausgang 110d eines Wählers durchgeschaltet wird, wird mit Hilfe eines Wahlanschlusses 110f am jeweiligen Wähler 110c festgelegt. Somit liegen an den Eingängen eines jeden Wählers 110c nur zwei Signale an, die Signalführung gestaltet sich entsprechend einfach und ist sehr gut in Silizium zu implementieren.

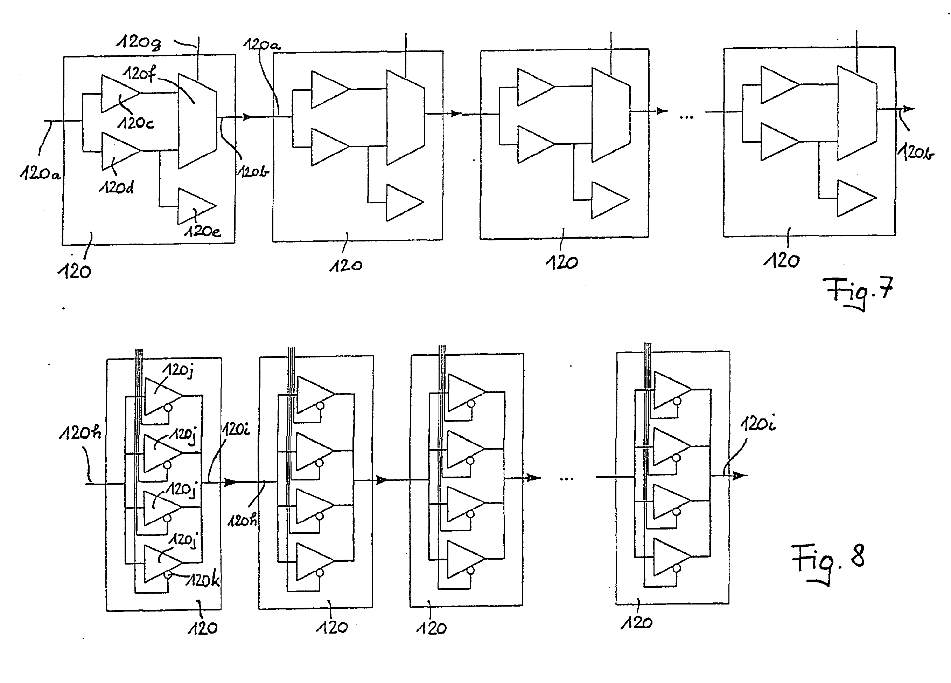

In Fig. 7 ist ein erstes Ausführungsbeispiel einer Feinverzögerungsstufe 12 zu erkennen. Dieses Ausführungsbeispiel der Feinverzögerungsstufe 12 umfasst mehrere Feinverzögerungselemente 120, die jeweils einen Eingang 120a und einen Ausgang 120b haben. Der Ausgang 120b eines vorangehenden Feinverzögerungselements 120 (z.B. das Feinverzögerungselement 120 ganz links) ist jeweils mit dem Eingang 120a des nachfolgenden Feinverzögerungselements 120 (das zweite Feinverzögerungselement 120 von links) verbunden. Der Ausgang 120b des letzten Feinverzögerungselements 120 ist gleichzeitig der Ausgang der Feinverzögerungsstufe 12.

Jedes Feinverzögerungselement 120 umfasst zwei Zweige, einen ersten Zweig mit einem sogenannten "Buffer" 120c, dessen Ausgang an einen Eingang eines Wählers 120f angeschlossen ist, und einen zweiten Zweig, in welchem ein weiterer Buffer 120d vorgesehen ist, dessen Ausgang einerseits mit einem weiteren Eingang des Wählers 120f verbunden ist und an dem andererseits ein weiterer Buffer 120e angehängt ist. Der Eingang des Feinverzögerungselements verzweigt sich auf die beiden Zweige (grundsätzlich könnten auch mehrere solche Zweige vorgesehen sein, bei dem gezeigten Ausführungsbeispiel sind es jedoch genau zwei).

Beim Durchlaufen des zweiten Zweigs (mit den Buffern 120d und 120e) benötigt das Signal mehr Zeit, bis es am Ausgang des Wählers 120f anliegt, weil der zweite Buffer 120e als kapazitive Last betrachtet werden kann, die erst aufgeladen werden muss, bevor dann das Signal am Eingang des Wählers liegt und auf dessen Ausgang 120b durchgeschaltet werden kann. Somit entspricht das Durchlaufen des zweiten Zweigs einer Zeitverzögerung, weil das Signal eben erst später am Eingang des Wählers und damit auch an dessen Ausgang anliegen kann. Der Wähler umfasst einen Wahlanschluss 120g , mit welchem ausgewählt werden kann, ob das Signal des ersten Zweigs oder das Signal des zweiten Zweigs auf den Ausgang 120b durchgeschaltet wird. So kann bei jedem einzelnen Feinverzögerungselement 120 separat eingestellt werden, ob das Signal, welches den ersten Zweig durchlaufen hat, oder das Signal, welches den zweiten Zweig durchlaufen hat, eingestellt werden. Dies entspricht nichts anderem als der Einstellung der Feinverzögerung, die in der weiter oben bereits ausführlich geschilderten Kalibrierung eingestellt wird.

In Fig. 8 ist ein zweites Ausführungsbeispiel der Feinverzögerungsstufe 12 mit mehreren Feinverzögerungselementen 120 dargestellt. Bei diesem Ausführungsbeispiel der Feinverzögerungsstufe 12 umfasst jedes Feinverzögerungselemente 120 einen Eingang 120h und einen Ausgang 120i. Der Ausgang 120i eines vorangehenden Feinverzögerungselements 120 (z.B. das Feinverzögerungselement 120 ganz links) ist jeweils mit dem Eingang 120h des nachfolgenden Feinverzögerungselements 120 (das zweite Feinverzögerungselement 120 von links) verbunden. Der Ausgang 120i des letzten Feinverzögerungselements 120 ist gleichzeitig der Ausgang der Feinverzögerungsstufe 12.

Jedes Feinverzögerungselement 120 umfasst mehrere Zweige, in denen jeweils ein sogenannter "Tristate-Buffer" 120j vorgesehen ist. Im dargestellten Ausführungsbeispiel sind es insgesamt vier parallele Zweige, in denen jeweils ein Tristate-Buffer 120j angeordnet ist. Der Eingang 120h des Feinverzögerungselements 120 verzweigt sich dabei auf die vier Zweige, in denen die Tristate-Buffer 120j angeordnet sind.

Der Wähler ist hier so ausgebildet, dass jeder Tristate-Buffer 120j mit Hilfe eines eigenen Wahlanschlusses 120k aktivierbar oder deaktivierbar ist. Die Tristate-Buffer weisen eine Eingangskapazität auf, unabhängig davon, ob sie aktiviert sind oder nicht. Je mehr Buffer innerhalb eines Feinverzögerungselements 120 aktiviert sind, desto weniger lange dauert es, bis die Eingangskapazität des nachfolgenden Verzögerungselements aufgeladen ist, und desto schneller liegt das Signal am Ausgang des jeweiligen Feinverzögerungselements 120 an. Die Kalibrierung der Feinverzögerungsstufe erfolgt auch hier in der bereits weiter oben beschriebenen Art und Weise.

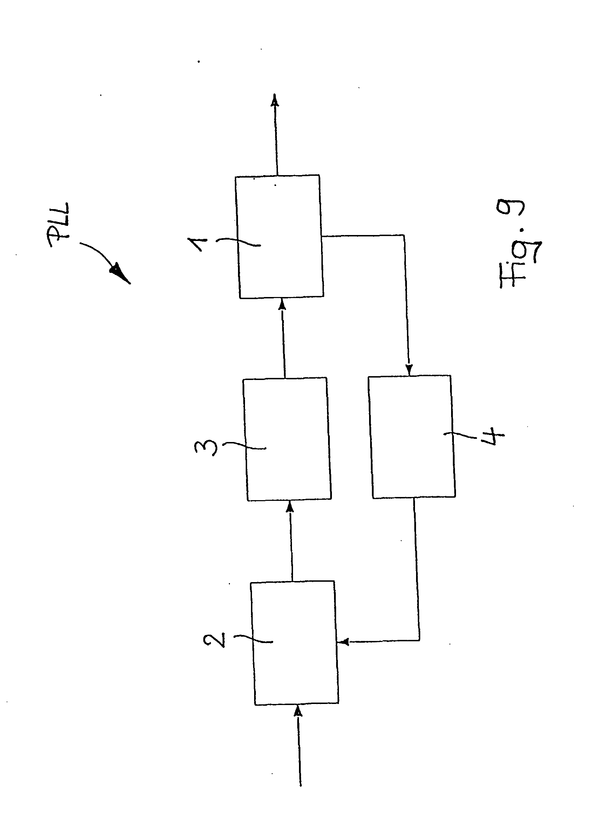

In Fig. 9 erkennt man in einem Blockschaltbild wesentliche Elemente einer Phasenabgleichsschaltung PLL (Phase-locked loop), welche einen digital gesteuerten Oszillator umfasst, wie er vorstehen beschrieben ist. Die Phasenabgleichsschaltung PLL umfasst einen Phasenkomparator 2, ein Filter 3 zum Herausfiltern von hochfrequentem Jitter, einen digital gesteuerten Oszillator 1, der so ausgebildet ist wie vorstehend beschrieben, sowie im Rückkopplungszweig einen Frequenzteiler 4.

Das mit Jitter behaftete Eingangs(takt)signal (das übrigens nicht zu verwechseln ist mit dem Eingangstaktsignal, welches durch den stabilen lokalen Oszillator des DCO erzeugt wird) soll durch ein jitterarmes Ausgangs-Taktsignal frequenz- und phasenrichtig nachgebildet werden. Dies erfolgt mit Hilfe des digital gesteuerten Oszillators, wie er vorstehend beschrieben ist, wobei am Phasenkomparator 2 die Phasenrichtigkeit überprüft wird.

## Patentansprüche

1. Digital gesteuerter Oszillator (1) zum Erzeugen eines phasenrichtigen Ausgangssignals einer gewünschten Frequenz, mit einem Eingang zum Zuführen eines digitalen Eingangsworts (100), mit einem Addierer (10) zum Aufsummieren der digitalen Eingangswörter (100), mit einem stabilen lokalen Oszillator zum Zuführen eines Taktsignals mit konstanter Frequenz, sowie mit einer Verzögerungsschaltung (11,12), welche eine Grobverzögerungsstufe (11) mit einer Mehrzahl von hintereinander geschalteten Grobverzögerungselementen (110) sowie eine Feinverzögerungsstufe (12) mit einer Mehrzahl von hintereinander geschalteten Feinverzögerungselementen (120) umfasst, wobei die Grobverzögerungsstufe (11) und die Feinverzögerungsstufe (12) so ausgebildet sind, dass die von der Grobverzögerungsstufe (11) und der Feinverzögerungsstufe (12) bewirkte Gesamtverzögerung so bemessen ist, dass sich die maximale Gesamtverzögerung und die minimale Gesamtverzögerung der Verzögerungsschaltung (11,12) um höchstens eine Periode des Taktsignals unterscheiden, und wobei die Mehrzahl von Feinverzögerungselementen (120) der Verzögerung eines Grobverzögerungselements (110) entspricht, **dadurch gekennzeichnet, dass** jedes Grobverzögerungselement (110) und jedes Feinverzögerungselement (120) einen eigenen ansteuerbaren Wähler (110c;120f;120k) umfasst wobei das Grobverzögerungselement (110) ein Verzögerungsglied (110b) und den Wähler (110c) umfasst, wobei ein Eingang des Wählers (110c) des jeweiligen Grobverzögerungselements (110) mit dem Ausgang des Verzögerungsglieds (110b) des gleichen Grobverzögerungselements (110) und ein weiterer Eingang des Wählers (110c) mit dem Ausgang (110d) des Wählers (110c) des unmittelbar nachgeschalteten Grobverzögerungselements (110) verbunden ist.

2. Digital gesteuerter Oszillator (1) nach Anspruch 1, bei welchem das Feinverzögerungselement (120) einen gemeinsamen Eingang (120a) aufweist, sowie mindestens zwei mit dem gemeinsamen Eingang verbundene Treiber (120c,120d), wobei am Ausgang von einem der beiden Treiber (120d) eine kapazitive Last (120e) vorgesehen ist, bei welchem Oszillator ferner ein Eingang des Wählers (120f) mit dem Ausgang des Treibers (120c) ohne die kapazitive Last und ein weiterer Eingang des Wählers (120f) mit dem Ausgang des Treibers (120d) mit kapazitiver Last (120e) verbunden ist, und bei welchem Oszillator der Ausgang des Wählers (120f) des jeweiligen Feinverzögerungselements (120) mit dem gemeinsamen Eingang (120a) des unmittelbar nachgeschalteten Feinverzögerungselements (120) verbunden ist.

3. Digital gesteuerter Oszillator nach Anspruch 1 , bei welchem das Feinverzögerungselement (120) mehrere Treiber (120j) umfasst, deren Eingänge miteinander zu einem gemeinsamen Eingang (120h) und deren Ausgänge miteinander zu einem gemeinsamen Ausgang (120i) verbunden sind, bei welchem ferner der Wähler (120k) derart ausgebildet ist, dass die einzelnen Treiber aktivierbar oder deaktivierbar sind, und bei welchem der gemeinsame Ausgang (120i) mit dem gemeinsamen Eingang (120h) des unmittelbar nachgeschalteten Feinverzögerungselements (120) verbunden ist.

4. Digitale Phasenabgleichsschaltung (PLL), mit einem Eingangstaktsignal, mit einem Phasenkomparator (2), mit einem Filter (3), mit einem digital gesteuerten Oszillator (1), und mit einem Rückkopplungszweig, welcher ein von dem digital gesteuerten Oszillator (1) erzeugtes Ausgangssignal zu dem Phasenkomparator (2) zurückführt, gegebenenfalls unter Frequenzvervielfachung (4) oder Frequenzteilung, **dadurch gekennzeichnet, dass** der digital gesteuerte Oszillator (1) gemäss einem der vorangehenden Ansprüche ausgebildet ist.

## Claims

1. A digitally controlled oscillator (1) for generating an in-phase output signal of a desired frequency, having an input for the supply of a digital input word (100), having an adder (10) for summing the digital input words (100), having a stable local oscillator for supplying a clock signal of constant frequency, and having a delay circuit (11, 12), which comprises a coarse delay stage (11) with a plurality of series-connected coarse delay units (110) and a fine delay stage (12) with a plurality of series-connected fine delay units (120), the coarse delay stage (11) and the fine delay stage (12) being configured such that the total delay brought about by the coarse delay stage (11) and the fine delay stage (12) is designed such that the maximum total delay and the minimum total delay of the delay circuit (11, 12) differ by at most one period of the clock signal, and the plurality of fine delay units (120) corresponding to the delay of one coarse delay unit (110), **characterised in that** each coarse delay unit (110) and each fine delay unit (120) has its own actuatable selector (110c; 120f; 120k), the coarse delay unit (110) comprising a delay element (110b) and the selector (110c), one input of the selector (110c) of the respective coarse delay unit (110) being connected to the output of the delay element (110b) of the same coarse delay unit (110) and a further input of the selector (110c) being connected to the output (110d) of the selector (110c) of the coarse delay unit (110) immediately downstream.

2. A digitally controlled oscillator (1) according to claim 1, in which the fine delay unit (120) comprises a common input (120a), and at least two drivers (120c, 120d) connected to the common input, a capacitive load (120e) being provided at the output of one of the two drivers (120d), in which oscillator furthermore one input of the selector (120f) is connected to the output of the driver (120c) without the capacitive load and a further input of the selector (120f) is connected to the output of the driver (120d) with capacitive load (120e), and in which oscillator the output of the selector (120f) of the respective fine delay unit (120) is connected to the common input (120a) of the fine delay unit (120) immediately downstream.

3. A digitally controlled oscillator according to claim 1, in which the fine delay unit (120) comprises a plurality of drivers (120j), the inputs of which are together connected to a common input (120h) and the outputs of which are together connected to a common output (120i), in which the selector (120k) is furthermore configured such that the individual drivers may be enabled or disabled, and in which the common output (120i) is connected to the common input (120h) of the fine delay unit (120) immediately downstream.

4. A digital phase-locked loop (PLL), having an input clock signal, having a phase comparator (2), having a filter (3), having a digitally controlled oscillator (1), and having a feedback loop, which feeds an output signal produced by the digitally controlled oscillator (1) back to the phase comparator (2), optionally with frequency multiplication (4) or frequency division, **characterised in that** the digitally controlled oscillator (1) is configured according to one of the preceding claims.

## Revendications

1. Oscillateur à commande numérique (1) pour produire un signal de sortie de phase correcte d'une fréquence souhaitée, comprenant une entrée pour l'alimentation d'un mot d'entrée numérique (100), un additionneur (10) pour faire la somme des mots d'entrée numériques (100), un oscillateur local stable pour l'alimentation d'un signal d'horloge de fréquence constante, et comprenant un circuit de temporisation (11, 12) qui comporte un étage de temporisation grossière (11) avec une pluralité d'éléments de temporisation grossière (110) montés les uns derrière les autres et un étage de temporisation fine (12) avec une pluralité d'éléments de temporisation fine (120) montés les uns derrière les autres, l'étage de temporisation grossière (11) et l'étage de temporisation fine (12) étant exécutés de manière à ce que la valeur de la temporisation totale réalisée par l'étage de temporisation grossière (11) et l'étage de temporisation fine (12) soit telle que l'écart entre la temporisation totale maximale et la temporisation totale minimale du circuit de temporisation (11, 12) corresponde au maximum à une période du signal d'horloge, et la pluralité d'éléments de temporisation fine (120) correspondant à la temporisation d'un élément de temporisation grossière (110), **caractérisé par le fait que** chaque élément de temporisation grossière (110) et chaque élément de temporisation fine (120) comprend son propre sélecteur (110c; 120f; 120k) qui peut être commandé, l'élément de temporisation grossière (110) comprenant un organe de temporisation (110b) et le sélecteur (110c), une entrée du sélecteur (110c) de l'élément de temporisation grossière respectif (110) étant reliée à la sortie de l'organe de temporisation (110b) du même élément de temporisation grossière (110) et une autre entrée du sélecteur (110c) étant reliée à la sortie (110d) du sélecteur (110c) de l'élément de temporisation grossière (110) immédiatement en aval.

2. Oscillateur à commande numérique (1) selon la revendication 1, dans lequel l'élément de temporisation fine (120) est pourvu d'une entrée commune (120a) et d'au moins deux circuits d'attaque (120c, 120d) reliés à l'entrée commune, une charge capacitive (120e) étant prévue à la sortie de l'un des deux circuits d'attaque (120d), oscillateur dans lequel, en outre, une entrée du sélecteur (120f) est reliée à la sortie du circuit d'attaque (120c) sans la charge capacitive et une autre entrée du sélecteur (120f) est reliée à la sortie du circuit d'attaque (120d) pourvu de la charge capacitive (120e), et dans lequel la sortie du sélecteur (120f) de l'élément de temporisation fine respectif (120) est reliée à l'entrée commune (120a) de l'élément de temporisation fine (120) immédiatement en aval.

3. Oscillateur à commande numérique selon la revendication 1, dans lequel l'élément de temporisation fine (120) comprend plusieurs circuits d'attaque (120j) dont les entrées sont reliées les unes aux autres pour former une entrée commune (120h) et dont les sorties sont reliées les unes aux autres pour former une sortie commune (120i), dans lequel, en outre, le sélecteur (120k) est exécuté de manière à ce que les circuits d'attaque individuels puissent être activés ou désactivés, et dans lequel la sortie commune (120i) est reliée à l'entrée commune (120h) de l'élément de temporisation fine (120) immédiatement en aval.

4. Circuit d'étalonnage numérique de la phase (PLL), comprenant un signal d'horloge d'entrée, un comparateur de phase (2), un filtre (3), un oscillateur à commande numérique (1) et une branche de rétroaction qui ramène un signal de sortie produit par l'oscillateur à commande numérique (1) vers le comparateur de phase (2), le cas échéant en lui faisant subir une multiplication de fréquence (4) ou une division de fréquence, **caractérisé par le fait que** l'oscillateur à commande numérique (1) est exécuté selon l'une des revendications précédentes.
